# DEMANDE DE BREVET EUROPEEN

(11) **EP 2 637 309 A1**
(43) Date de publication de la demande: **11.09.2013**
(21) Numéro de dépôt: 13157469.1
(22) Date de dépôt: 01.03.2013
(51) Int. Cl.: H03K 19/173, G01R 31/02

(54) **Dispositif de circuit logique comprenant au moins une entrée numérique**

(30) Priorité: 08.03.2012 FR 1200701
(71) Demandeur: Thales, 92200 Neuilly Sur Seine (FR)
(72) Inventeur: Rochas, Vincent, 26120 Chabeuil (FR)
(74) Mandataire: Brunelli, Gérald

(57) **Abrégé**

L'invention porte sur un dispositif de circuit logique comprenant au moins une entrée numérique munie d'un fusible (FUS) étant, à l'état fermé, adapté pour appliquer une tension électrique d'entrée du circuit logique correspondant à un premier état logique parmi les états logiques 0 et 1, et, à l'état ouvert définitif, adapté pour appliquer une tension électrique d'entrée du circuit logique correspondant au deuxième état logique parmi les états logiques 0 et 1, ledit fusible (FUS) étant adapté pour être mis définitivement au deuxième état logique par injection d'un courant supérieur à un courant de seuil (CS).

## Description

La présente invention porte sur un dispositif de circuit logique comprenant au moins une entrée numérique.

Il est connu des circuits logiques comprenant au moins une entrée numérique, tels des circuits intégrés propres à une application ou ASIC comme acronyme de "Application-Specific Integrated Circuit" en langue anglaise.

Il est connu des systèmes permettant de fixer un niveau logique de manière inaltérable sur une entrée numérique.

Par exemple, il est possible de fixer les entrées d'un circuit logique par câblage, avec deux résistances, et en câblant soit l'une soit l'autre le niveau logique est modifié. En ce cas, les entrées sont déterminées avant assemblage de la carte électronique, et les composants montés définissent les niveaux logiques.

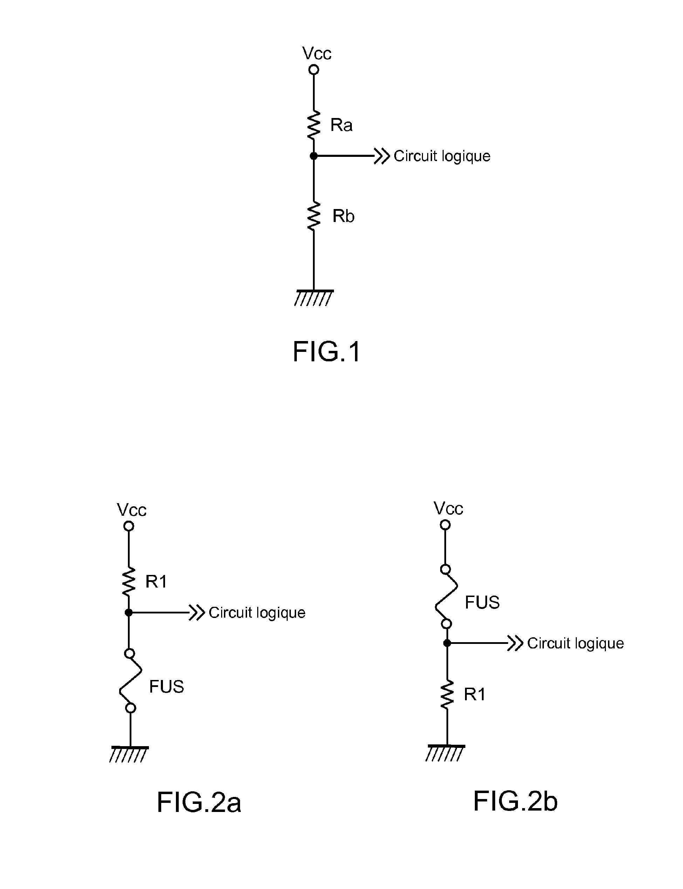

La figure 1 illustre un tel mode de réalisation, sur lequel deux résistances Ra et Rb, par exemple de l'ordre de 100 kΩ, et Vcc représente l'alimentation électrique du dispositif.

Une telle mise en oeuvre est contraignante, car les paramètres à programmer doivent être définis avant que la carte électronique ne soit câblée.

Il est également connu de relier électriquement deux surfaces isolées électriquement l'une de l'autre avec des fils conducteurs mais cette technique est complexe et coûteuse.

Il est aussi connu lier deux surfaces isolées électriquement l'une de l'autre, à l'aide d'une colle conductrice ou d'une soudure afin d'assurer la connexion électrique.

Enfin, il est connu de découper de piste de cuivre par exemple par laser, ou au moyen d'un objet coupant tel un cutter ou un scalpel, afin de supprimer une connexion électrique entre deux surfaces isolées électriquement l'une de l'autre. Cette technique nécessite des formes particulières du substrat pour réaliser la découpe.

Mais toutes ces solutions nécessitent une intervention physique sur la carte électronique, ce qui est souvent long, coûteux et contraignant.

Un but de l'invention est de proposer un dispositif moins coûteux et plus aisé à mettre en oeuvre.

Il est proposé, selon un aspect de l'invention, un dispositif de circuit logique comprenant au moins une entrée numérique munie d'un fusible étant, à l'état fermé, adapté pour appliquer une tension électrique d'entrée du circuit logique correspondant à un premier état logique parmi les états logiques 0 et 1, et, à l'état ouvert définitif, adapté pour appliquer une tension électrique d'entrée du circuit logique correspondant au deuxième état logique, opposé au premier état logique, parmi les états logiques 0 et 1, ledit fusible étant adapté pour être mis définitivement au deuxième état logique par injection d'un courant supérieur à un courant de seuil. ladite entrée numérique comprend, en outre, une première résistance de maintien de potentiel électrique d'entrée correspondant au deuxième état logique, et un ensemble comprenant une deuxième résistance de limitation de courant dans le fusible et un troisième point d'entrée électrique de test connectés électriquement, ledit ensemble étant connecté électriquement entre le fusible et la première résistance.

Un tel dispositif permet de réaliser un dispositif de manière générique, donc de coût réduit, pour lequel il est aisé, par la suite de fixer de manière inaltérable le niveau logique de l'entrée numérique du circuit logique. Lorsque l'entrée numérique est munie d'un fusible adapté pour appliquer, à l'état fermé une tension électrique d'entrée du circuit logique correspondant à un premier état logique 0, alors à l'état ouvert définitif il est adapté pour applique une tension électrique d'entrée du circuit logique correspondant au deuxième état logique 1, et réciproquement, lorsque l'entrée numérique est munie d'un fusible adapté pour appliquer, à l'état fermé une tension électrique d'entrée du circuit logique correspondant à un premier état logique 1, alors à l'état ouvert définitif il est adapté pour applique une tension électrique d'entrée du circuit logique correspondant au deuxième état logique 0.

En outre, l'encombrement est alors réduit.

La présence de cette première résistance permet le maintien du potentiel électrique d'entrée correspondant au deuxième état logique correspondant au fusible ouvert, lorsque le fusible est ouvert la résistance fixe le niveau logique inverse à celui fixé par le fusible dans son état fermé.

L'utilisation de cet ensemble permet de limiter le courant dans le fusible, pour qu'il ne s'ouvre pas lorsqu'on applique, lors d'un test, un courant électrique et/ou une tension électrique correspondant au deuxième état logique sur l'entrée correspondante.

Aussi, lorsque l'on souhaite ouvrir le fusible de façon correcte, il est nécessaire d'appliquer la tension nominale indiquée par le constructeur du fusible.

Mais cette tension (généralement de l'ordre de 30V) est supérieure à la tension admissible par l'entrée du circuit numérique (généralement au maximum de 1,6V pour les logiques 1,2V et 6V pour les logiques 5V) sous peine de destruction.

Grâce à l'ajout de la deuxième résistance R2 et du troisième point d'entrée électrique de test Ptest, il est possible pendant l'ouverture du fusible de protéger l'entrée du circuit numérique. Pour ce faire, il faut relier le troisième point d'entrée électrique de test Ptest à la masse, pendant que la tension et le courant nominaux du fusible sont appliqués au deuxième point d'entré électrique Pmef pour ouvrir le fusible.

Par exemple, ledit fusible est relié électriquement en une première extrémité à la masse et en une deuxième extrémité à l'entrée numérique, et la première résistance est disposée entre l'entrée numérique et un premier point d'entrée électrique d'alimentation du circuit logique.

Ainsi, à l'état ouvert définitif, la première résistance permet de fournir une entrée à l'état logique 1. En outre, à l'état fermé, le fusible permet de fournir une entrée à l'état logique 0.

En variante, la première résistance est reliée électriquement en une première extrémité à la masse et en une deuxième extrémité à l'entrée numérique, et le fusible est disposé entre l'entrée numérique et un premier point d'entrée électrique d'alimentation du circuit logique.

Ainsi, à l'état ouvert définitif, la première résistance permet de fournir une entrée à l'état logique 0. En outre, à l'état fermé, le fusible permet de fournir une entrée à l'état logique 1.

Dans un mode de réalisation, ladite entrée numérique comprend, en outre, un deuxième point d'entrée électrique de mise à l'état ouvert définitif du fusible, directement connecté électriquement à un lien électrique entre la première résistance et le fusible.

Il est ainsi aisé, après réalisation d'une carte électronique, de pouvoir mettre à l'état ouvert définitif les fusibles correspondant à des entrées numériques du circuit logique devant être au deuxième état logique.

La valeur du courant de seuil peut dépendre de caractéristiques de fonctionnement du fusible.

Dans un mode de réalisation, la valeur de la première résistance est supérieure à une première résistance de seuil dépendant de caractéristiques de fonctionnement du circuit logique et du fusible.

Selon un mode de réalisation, la valeur de la deuxième résistance est supérieure à une deuxième résistance de seuil dépendant de caractéristiques du fusible.

Dans un mode de réalisation, le fusible est adapté pour passer définitivement à l'état ouvert à un courant électrique inférieur ou égal à 500 mA.

En outre, le fusible peut avoir une surface d'occupation inférieure ou égale à 5 mm².

L'invention sera mieux comprise à l'étude de quelques modes de réalisation décrits à titre d'exemples nullement limitatifs et illustrés par les dessins annexés sur lesquels :
- la figure 1 illustre schématiquement un dispositif de circuit logique comprenant au moins une entrée numérique, selon l'état de la technique
- les figures 2a et 2b illustrent schématiquement deux dispositifs de circuit logique comprenant au moins une entrée numérique, munis d'un fusible câblé, selon un aspect de l'invention ;
- les figures 3a et 3b illustrent schématiquement deux dispositifs respectivement selon les figures 2a et 2b, munis d'un point d'entrée électrique de mise à l'état ouvert définitif du fusible, selon un aspect de l'invention ; et
- les figures 4a et 4b illustrent schématiquement deux dispositifs respectivement selon les figures 3a et 3b, munis d'une deuxième résistance de limitation de courant dans le fusible et d'un point d'entrée électrique de test, selon un aspect de l'invention.

Sur l'ensemble des figures, les éléments ayant des références identiques sont similaires.

Tel qu'illustré sur la figure 2a, le dispositif de circuit logique comprend au moins une entrée numérique, en l'espèce une, munie d'un fusible FUS, connecté électriquement en une première extrémité à la masse. Le fusible FUS est, à l'état fermé, adapté pour permettre une tension électrique d'entrée du circuit logique correspondant à un état logique 0, et, à l'état ouvert définitif, adapté pour permettre une tension électrique d'entrée du circuit logique correspondant à un état logique 1. Le fusible FUS est adapté pour être mis définitivement à l'état ouvert par injection d'un courant supérieur à un courant de seuil CS, le faisant passer à l'état ouvert définitif.

L'entrée numérique comprend, en outre, une première résistance R1 de maintien du potentiel électrique d'entrée à un potentiel électrique correspondant à l'état logique 1, disposée entre une deuxième extrémité du fusible FUS et un premier point d'entrée électrique Vcc d'alimentation du circuit logique.

Tel qu'illustré sur la figure 2b, en variante du dispositif de la figure 2a, le dispositif de circuit logique comprend au moins une entrée numérique, en l'espèce une, munie d'un fusible FUS, connecté électriquement en une première extrémité à un premier point d'entrée électrique Vcc d'alimentation du circuit logique. Le fusible FUS est, à l'état fermé, adapté pour permettre une tension électrique d'entrée du circuit logique correspondant à un état logique 1, et, à l'état ouvert définitif, adapté pour permettre une tension électrique d'entrée du circuit logique correspondant à un état logique 0. Le fusible FUS est adapté pour être mis définitivement à un état ouvert par injection d'un courant supérieur à un courant de seuil CS, le faisant passer à l'état ouvert définitif.

L'entrée numérique comprend, en outre, une première résistance R1 de maintien du potentiel électrique d'entrée à un potentiel électrique correspondant à l'état logique 0, disposée entre une deuxième extrémité du fusible FUS et la masse.

Par exemple, le courant de seuil CS peut être inférieur à 500 mA.

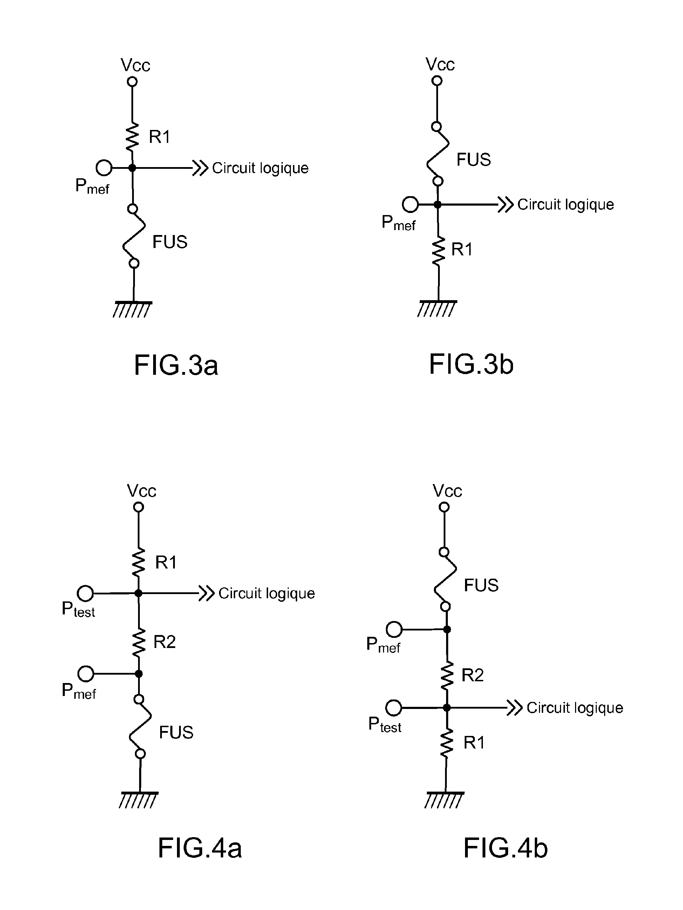

La figure 3a est un dispositif similaire à celui de la figure 2a, muni, en outre, d'un deuxième point d'entrée électrique Pmef de mise à l'état ouvert définitif du fusible. Le deuxième point d'entrée électrique Pmef est directement connecté électriquement à la deuxième extrémité du fusible FUS non reliée à la masse, et directement connecté électriquement à l'autre extrémité de la première résistance R1, non connectée électriquement au point d'entrée Vcc de tension électrique d'alimentation du circuit logique.

Il est ainsi aisé après réalisation d'une carte électronique générique, par l'intermédiaire d'un outillage injectant un courant suffisant, i.e. supérieur à un seuil pouvant dépendre des caractéristiques du fusible FUS, de mettre à l'état ouvert définitif les fusibles FUS dont l'entrée numérique correspondante doit avoir un état logique définitif à 1.

La figure 3b est un dispositif similaire à celui de la figure 2b, muni, en outre, d'un deuxième point d'entrée électrique Pmef de mise à l'état ouvert définitif du fusible. Le deuxième point d'entrée électrique Pmef est directement connecté électriquement à la deuxième extrémité du fusible FUS non reliée électriquement au premier point d'entrée électrique Vcc d'alimentation du circuit logique, et directement connecté électriquement à l'autre extrémité de la première résistance R1, non connectée électriquement à la masse.

Il est ainsi aisé après réalisation d'une carte électronique générique, par l'intermédiaire d'un outillage injectant un courant suffisant, i.e. supérieur à un seuil pouvant dépendre des caractéristiques du fusible FUS, de mettre à l'état ouvert définitif les fusibles FUS dont l'entrée numérique correspondante doit avoir un état logique définitif à 0.

Sur la figure 4a est présenté un dispositif semblable à celui de la figure 3a, mais muni, en outre, d'un ensemble comprenant une deuxième résistance R2 de limitation de courant dans le fusible FUS et un troisième point d'entrée électrique Ptest de test connectés électriquement, ledit ensemble étant connecté électriquement entre le fusible FUS et la première résistance R1.

La deuxième résistance R2 est disposée entre l'extrémité du fusible FUS non reliée à la masse et l'extrémité de la première résistance R1 non reliée au premier point d'entrée électrique Vcc d'alimentation du circuit logique. Le troisième point d'entrée électrique de test Ptest est directement connecté électriquement à un lien électrique entre la première résistance R1 et la deuxième résistance R2.

La première résistance R1 peut généralement avoir une valeur comprise entre 1 kΩ et 10000 kΩ, par exemple de l'ordre de 100 kΩ, et la deuxième résistance R2 une valeur de l'ordre du dixième de celle de R1, par exemple de l'ordre de 10 kΩ.

Sur la figure 4b est présenté un dispositif semblable à celui de la figure 3b, mais muni, en outre, d'un ensemble comprenant une deuxième résistance R2 de limitation de courant dans le fusible FUS et un troisième point d'entrée électrique Ptest de test connectés électriquement, ledit ensemble étant connecté électriquement entre le fusible FUS et la première résistance R1.

La deuxième résistance R2 est disposée entre l'extrémité de la première résistance R1 non reliée à la masse et l'extrémité du fusible FUS non reliée au premier point d'entrée électrique Vcc d'alimentation du circuit logique. Le troisième point d'entrée électrique de test Ptest est directement connecté électriquement à un lien électrique entre la première résistance R1 et la deuxième résistance R2.

La première résistance R1 peut généralement avoir une valeur comprise entre 1 kΩ et 10000 kΩ, par exemple de l'ordre de 100 kΩ, et la deuxième résistance R2 une valeur de l'ordre du dixième de celle de R1, par exemple de l'ordre de 10 kΩ.

La valeur de la résistance R1 dépend des caractéristiques de tension et courant de l'entrée numérique. Le choix du fusible FUS dépend également des caractéristiques de l'entrée numérique. La valeur de la résistance R2 dépend du courant de seuil d'ouverture du fusible FUS.

Dans l'ensemble des exemples précédents, on peut préférentiellement utiliser des fusibles FUS adaptés pour passer définitivement à l'état ouvert à un courant électrique inférieur ou égal à 500 mA, et ayant une surface d'occupation inférieure ou égale à 5 mm².

## Revendications

1. Dispositif de circuit logique comprenant au moins une entrée numérique munie d'un fusible (FUS) étant, à l'état fermé, adapté pour appliquer une tension électrique d'entrée du circuit logique correspondant à un premier état logique parmi les états logiques 0 et 1, et, à l'état ouvert définitif, adapté pour appliquer une tension électrique d'entrée du circuit logique correspondant au deuxième état logique, opposé au premier état logique, parmi les états logiques 0 et 1, ledit fusible (FUS) étant adapté pour être mis définitivement au deuxième état logique par injection d'un courant supérieur à un courant de seuil (CS), dans lequel ladite entrée numérique comprend, en outre, une première résistance (R1) de maintien de potentiel électrique d'entrée correspondant au deuxième état logique, et un ensemble comprenant une deuxième résistance (R2) de limitation de courant dans le fusible (FUS) et un troisième point d'entrée électrique de test (Ptest) connectés électriquement, ledit ensemble étant connecté électriquement entre le fusible (FUS) et la première résistance (R1).

2. Dispositif selon la revendication 1, dans lequel le fusible (FUS) est relié électriquement en une première extrémité à la masse et en une deuxième extrémité à l'entrée numérique, et la première résistance (R1) est disposée entre l'entrée numérique et un premier point d'entrée électrique (Vcc) d'alimentation du circuit logique.

3. Dispositif selon la revendication 1, dans lequel la première résistance (R1) est reliée électriquement en une première extrémité à la masse et en une deuxième extrémité à l'entrée numérique, et le fusible (FUS) est disposé entre l'entrée numérique et un premier point d'entrée électrique (Vcc) d'alimentation du circuit logique.

4. Dispositif selon l'une des revendications 1 à 3, dans lequel ladite entrée numérique comprend, en outre, un deuxième point d'entrée électrique (Pmef) de mise à l'état ouvert définitif du fusible (FUS), directement connecté électriquement à un lien électrique entre la première résistance (R1) et le fusible (FUS).

5. Dispositif selon l'une des revendications 1 à 4, comprenant, en outre, un ensemble comprenant une deuxième résistance (R2) de limitation de courant dans le fusible (FUS) et un troisième point d'entrée électrique de test (Ptest) connectés électriquement, ledit ensemble étant connecté électriquement entre le fusible (FUS) et la première résistance (R1).

6. Dispositif selon l'une des revendications précédentes, dans lequel la valeur du courant de seuil (CS) dépend de caractéristiques de fonctionnement du fusible.

7. Dispositif selon l'une des revendications précédentes, dans lequel la valeur de la première résistance (R1) est supérieure à une première résistance de seuil dépendant de caractéristiques de fonctionnement du circuit logique et du fusible (FUS).

8. Dispositif selon l'une des revendications précédentes, dans lequel la valeur de la deuxième résistance (R2) est supérieure à une deuxième résistance de seuil dépendant de caractéristiques du fusible (FUS).

9. Dispositif selon l'une des revendications précédentes, dans lequel le fusible (FUS) est adapté pour passer définitivement à l'état ouvert à un courant électrique inférieur ou égal à 500 mA.

10. Dispositif selon l'une des revendications précédentes, dans lequel le fusible (FUS) a une surface d'occupation inférieure ou égale à 5 mm².
